# EUROPÄISCHE PATENTSCHRIFT

(11) **EP 1 413 647 B1**
(45) Veröffentlichungstag und Bekanntmachung des Hinweises auf die Patenterteilung: **30.04.2008**
(21) Anmeldenummer: 03017451.0
(22) Anmeldetag: 01.08.2003
(51) Int. Cl.: C23C 28/00, C23C 14/06, C23C 30/00

(54) **Verschleissschutzschicht**
Wear resistant coating
Couche résistante à l'usure

(30) Priorität: 11.09.2002 DE 10242475
(43) Veröffentlichungstag der Anmeldung: 28.04.2004
(73) Patentinhaber: Forschungszentrum Karlsruhe GmbH, 76133 Karlsruhe (DE)
(72) Erfinder: Stüber, Michael, Dr., 76829 Landau (DE); Ulrich, Sven, Dr., 76297 Stutensee (DE); Bauer, Christiane, 76149 Karlsruhe (DE)

(56) Entgegenhaltungen:
- DE-A1- 3 639 469
- DE-A1- 4 211 829
- US-A1- 2001 024 598
- US-A1- 2002 094 378
- US-A1- 2002 098 083
- STUBER M ET AL: "Microstructure and properties of low friction TiC-C nanocomposite coatings deposited by magnetron sputtering" SURFACE & COATINGS TECHNOLOGY ELSEVIER SWITZERLAND, Bd. 150, Nr. 2-3, 15. Februar 2002 (2002-02-15), Seiten 218-226, XP002352234 ISSN: 0257-8972
- BAUER C ET AL: "Mechanical properties and performance of magnetron-sputtered graded diamond-like carbon films with and without metal additions" DIAMOND AND RELATED MATERIALS, ELSEVIER SCIENCE PUBLISHERS, AMSTERDAM, NL, Bd. 11, Nr. 3-6, März 2002 (2002-03), Seiten 1139-1142, XP004357091 ISSN: 0925-9635

## Beschreibung

Die Erfindung betrifft eine Verschleißschutzschicht, bestehend aus einer Vielzahl von in periodisch wiederholter Abfolge auf ein Substrat abwechselnd übereinander aufgetragenen ersten und zweiten Einzellagen, welche jeweils mindestens eine Hartstoffphase enthalten, gemäß dem Oberbegriff des ersten Patentanspruchs.

Aus der DE 42 11 829 C2 ist ein Verfahren zur Herstellung einer Mehrlagen-Hartbeschichtung bekannt, die eine Titanverbindungsschicht (z.B. TiC), eine Titanverbindungsschicht mit einem Anteilsgradienten an Kohlenstoff zur Verbesserung der Haftfestigkeit und eine dritte Schicht aus amorphen Kohlenstoff mit 4 - 40 Mol% TiC umfasst.

Die DE 198 26 259 A1 offenbart eine Multilagenstruktur aus alternierenden Einzelschichten, bestehend aus alternierenden Hartstoff- und Kohlenstoffschichten geringer Schichtdicken, wobei jedoch keine Mengenverhältnisse der Hartstoff- und Kohlenstoffschichten offenbart werden.

Ein Schichtsystem nach DE 36 39 469 A1 umfasst neben Hartstoffschichten eine Kohlenstoff-Deckschicht mit 5 - 30 Gew% eingelagerten Kristalliten des Karbides der Zwischenschicht.

Schließlich offenbart DE 44 21 144 C2 ein beschichtetes Werkzeug mit erhöhter Standzeit, wobei die Beschichtung mindestens eine Hartstoffschicht und eine Reibminderungsschicht aufweist. Die Reibminderungsschicht ist u. a. eine Mischung von Metallcarbiden Kohlenstoff mit einem Gesamt-Kohlenstoffanteil größer 61 at%.

Verschleißschutzschichten, bestehend aus einer Vielzahl von Einzellagen sind aus der DE 195 03 070 C1 bekannt, wobei als die zur Anwendung kommenden Materialien insbesondere kovalente oder metallische Hartstoffe genannt werden. Die Einzellagen werden in einer PVD-Anlage mit Targets aus Metall oder metallische oder kovalente Hartstoffe aufgesputtert, wobei die Substrate beispielsweise auf einem Drehteller angeordnet unter mehreren Targets in der PVD-Anlage periodisch durchgeführt werden. Dabei erfolgt das Aufsputtern von metallischen und kovalenten Hartstoffen im Wechsel, wobei sich bestimmte mechanische Eigenschaften beider Materialgruppen miteinander kombinieren lassen. Die Verbindungen zwischen den Einzellagen untereinander und zu den Substratmaterialien sind adhäsiv.

Grundsätzlich neigen viele Hartstoffe mit einem hohen kovalenten Bindungsanteil zu einer schlechten Haftung auf metallischen Substraten. Diese ungünstige Gegebenheit versuchte man in der DE 195 03 070 C1 durch eine erste, auf dem Substrat aufliegende Einzelschicht aus einem metallischen Hartstoff, welcher vergleichsweise gut auf den für Werkzeuge eingesetzten Stählen oder Hartmetallen haftet, zu umgehen. Dünne Schichtdicken der Einzellagen reduzieren dabei negative Wirkungen von charakteristischen Eigenschaften der Hartstoffschichten, wie z.B. das hohe Eigenspannungsniveau oder die ausgeprägte Sprödigkeit, und verbessern so die adhäsive Haftung zu benachbarten Lagen und zu dem Substratmaterial noch zusätzlich. Als Dicke der Einzellagen aus dem kovalenten Hartstoff, welche höchstens die Hälfte, besser weniger als ein Fünftel der Dicke der Einzellagen aus den metallischen Hartstoffen betragen, wird ein Bereich zwischen 1 und 30 nm, besser zwischen 1 und 5 nm angegeben. Die Einzellagen aus den metallischen Hartstoffen weisen Dicken bis zu 500 nm auf.

Davon ausgehend ist es Aufgabe der Erfindung, eine weitere, aus einer Vielzahl von alternierenden Einzellagen bestehende Verschleißschutzschicht der eingangs genannten Art vorzuschlagen, welche die genannten Nachteile und stofflichen und geometrischen Einschränkungen, welche sich aus der adhäsiven Bindungen ergeben, nicht oder nur in reduzierter Form aufweist. Zudem soll sich die Verschleißschutzschicht durch einen hohen Verschleißwiderstand einerseits und einem geringen Reibwert andererseits auszeichnen.

Die Aufgabe wird durch die kennzeichnenden Merkmale des ersten Patentanspruchs gelöst. Bevorzugte Ausführungsformen der Erfindung sind Gegenstand der Unteransprüche.

Die kennzeichnenden Merkmale der Erfindung betreffen den Aufbau und die Morphologie der beiden Einzellagen. Insbesondere bestehen die Einzellagen nicht nur aus einem kristallinen Hartstoffphasenanteil, sondern weisen zudem eine amorphe Kohlenstoffphase als weitere Phase auf. Sie sind somit Compositelagen, welche sich aus mehreren Phasen mit homogener Verteilung und einem festen Phasenverhältnis zusammensetzen. Dabei liegt der Hartstoffphasenanteil als nanokristalline Phase und der Kohlenstoff vorzugsweise als amorphe Phase vor, wobei entweder der Hartstoffphasenanteil oder der Kohlenstoffphasenanteil in Form von Einzelpartikel in mindestens einer Modifikation in einer Matrix, bestehend aus dem jeweils anderem Phasenanteil, fest eingebunden ist.

Als Hartstoffphasenanteil eignet sich neben Titancarbid (TiC) insbesondere Titanaluminiumnitrid (TiAlN) und Titanaluminiumcarbonitrid (TiAlCN), jeweils in der metastabilen nanokristallinen Modifikation.

Die mechanischen Eigenschaften der Einzellagen lassen sich in besonders vorteilhafter Weise durch die Anteile der Phasenzusammensetzungen einstellen. Grundsätzlich begünstigt ein steigender Kohlenstoffanteil dabei einen geringen Gleitreibungswiderstand, ein steigender Hartstoffanteil hohe Härte- und Zähigkeitswerte einer Einzelschicht. Der Übergang ist im wesentlichen fließend, sodass die mechanischen und tribologischen Eigenschaften einer Verschleißschutzschicht exakt auf den vorgesehenen Einsatz und auf die vorgesehene Reibpaarung gezielt auslegbar ist.

Die beiden Einzellagen unterscheiden sich insbesondere im Verhältnis des Hartstoffphasenanteils zum Kohlenstoffphasenanteils.

Stellt der Kohlenstoffphasenanteil den überwiegenden Anteil, d.h. vorzugsweise über 50 mol%, der Einzellage dar, bildet sich mit zunehmenden Kohlensstoffanteil eine Kohlenstoffmatix, in der die Hartstoffphasenanteile als Partikel eingelagert sind. Es entsteht so ein dispersionsgehärteter amorpher Kohlenstoff mit geringen Reibwerten, aber mit einer erheblich erhöhten Verschleißfestigkeit im Vergleich zu Einzelschichten aus reinem amorphen Kohlenstoff.

Stellt der Hartstoffphasenanteil den überwiegenden Anteil, d.h. vorzugsweise über 50 mol%, einer Einzellage dar, bildet sich mit dem zunehmenden Anteil eine Hartstoffmatrix, in die der amorphe Kohlenstoffphasenanteil nicht nur als Partikel oder als Korngrenzenphase, sondern auch als Einlagerungen oder in Zwischengitterplätzen eingesetzt ist. Auf diese Weise entsteht eine Einzellage mit Eigenschaften mit ähnlich eines reinen Hartstoffes mit intrinsischer Schmierung, d. h. mit hoher Zähigkeit und verringertem Reibwert.

Durch die Gestaltung einer Verschleißschutzschicht in der zuvor beschriebenen Art, d. h. als Multilayer-Schichtverbund aus einer Vielzahl von in periodisch wiederholter Abfolge auf ein Substrat abwechselnd übereinander aufgetragenen ersten und zweiten Einzellagen, welche sich aus den gleichen Phasen, jedoch mit unterschiedlichen Phasenanteilen, zusammensetzen, erhält man eine im Vergleich zu adhäsiven Verbindungen vorteilhafte stoffschlüssige Verbindung der Einzellagen untereinander. Dabei bleiben die eingangs genannten Vorteile von Schichtverbünden erhalten.

Über den Reibwert und den Verschleißwiderstand der Verschleißschutzschicht entscheidet im wesentlichen die Zusammensetzung und Dicke der obersten Einzellage in zuvor genannter Weise.

Den darunter liegenden Einzellagen beeinflussen das Verschleiß- und Reibverhalten der Verschleißschutzschicht dagegen nur indirekt über deren Steifigkeit bzw. Nachgiebigkeit, deren Haftungsvermögen zu den benachbarten Einzellagen sowie deren Risswiderstand.

Wird die oberste Einzellage der Verschleißschutzschicht durch Reibungsverschleiß lokal durchbrochen, kommt die darunter liegende Einzellage mit anderer Zusammensetzung und Eigenschaftsprofil zum Vorschein. Durch diese Änderung des Eigenschaftsprofils lässt sich während eines Einsatzes ein Versagen der Verschleißschutzschicht in besonders vorteilhafter Weise allein durch Messen der an der anliegenden Kräfteverhältnisse erfassen.

Es ist zudem unerheblich, ob auch weitere Einzellagen mit anderen Phasenanteilverhältnissen in die periodische wiederholten Abfolge eingebracht sind. Verschleißschutzschichten aus einer Vielzahl von in periodisch wiederholter Abfolge auf ein Substrat abwechselnd übereinander aufgetragenen mehr als zwei Einzellagen, welche den zuvor genannten Kriterien entsprechen, liegen somit im Rahmen der Erfindung.

Die Dicke einer Verschleißschutzschicht liegt bei maximal 20 µm, vorzugsweise unterhalb 5 µm. Die Anzahl der Einzellagen liegt unterhalb 1000, vorzugsweise zwischen 10 und 500. Ein Optimum findet man mit einer Anzahl von Einzellagen zwischen 100 und 200. Hierdurch ergibt sich eine Dicke für eine Einzellage im Nanometerbereich, vorzugsweise zwischen 5 und 500nm. Um ein quasihomogenes Materialverhalten einer Einzellage sicherzustellen, dürfen die einen Phasenanteile, welche als Einlagerung in der Matrix aus einem anderen Phasenanteil in der Einzellage vorliegen, eine bestimmte Partikelgröße nicht überschreiten. Die Partikelgröße der Einlagerung liegt daher im Nanometerbereich, vorzugsweise zwischen 5 und 20 nm.

Es bietet sich zudem an, die unterste Einzellage, welche direkt auf das Substrat aufgebracht wird, vorzugsweise aus einem Phasengemisch mit einem überwiegenden Anteil derjenigen Phase herzustellen, welche die besseren adhäsive oder stoffschlüssige Verbindungspotential zum Substratmaterial aufweist.

Zur Herstellung derartiger Einzellagen bietet sich ein PVD-Magnetron-Sputterprozeß an. Die mehrphasige Abscheidung einer Einzellage erfolgt dabei in einer nichtreaktiven Atmosphäre mit einem Target, welches die im Wesentlichen gleiche Phasenzusammensetzung der abzuscheidenden Einzelphase aufweist. Dabei ist die Abscheidungsrate der Einzellage sowie die Beschaffenheit der abzuscheidenden Phasen über den Druck und die Temperatur der Atmosphäre sowie über die Hohe des zwischen Target und zu beschichteten Materials angelegten elektrischen Potentialunterschieds beeinflussbar. Die geforderten Einlagerungen im Nanometerbereich sowie eine amorphe Kohlenstoffphase erreicht man im Allgemeinen durch eine hohe Keimbildungsrate, welche durch eine hohen Potentialunterschied sowie durch eine geringe Temperatur und einem niedrigen Druck der Atmosphäre auszeichnet.

Die Erfindung wird anhand eines Ausführungsbeispiels einer Verschleißschutzschicht mit Titancarbid als Hartstoffphasenanteil erläutert.

In einer Versuchsreihe wurden polierte Substrate aus einem Stahl 100Cr6 oder Hartmetall mit unterschiedlichen Verschleißschutzschichten, bestehend aus einer Vielzahl von in periodisch wiederholter Abfolge abwechselnd übereinander aufgetragenen ersten und zweiten Einzellagen, beschichtet. Die erste Einzellage besteht aus 70 mol% amorphen Kohlenstoffphasenanteil und 30 mol% nanokristallinen Titancarbidphasenanteil (im Folgenden TiC/C(30/70) genannt), während die zweite Einzellage sich aus 30 mol% amorphem Kohlenstoffphasenanteil und 70 mol% nanokristallinem Titancarbidphasenanteil (im Folgenden TiC/C(70/30) genannt) zusammensetzt.

Für die Beschichtung wurden zwei Targets mit 75 mm Durchmesser und den zuvor genannten Zusammensetzungen über einen herkömmlichen Heißpress-Sintervorgang hergestellt. Die Targets wurden in der Sputterkammer einer PVD-Sputteranlage ca. 50 mm über den Substraten auf einen Drehteller positioniert. Die Einzellagen wurden unter einer Argon-Atmosphäre mit 0,6 Pa Druck aufgesputtert. Als typische Parameterbereiche für den PVD-Beschichtungsprozeß für die Verschleißschutzschichten werden angegeben: 0,2 bis 0,8 Pa Argondruck, 50 bis 500 W Gleichspannung am Target, d.h. Leistungsdichte zwischen 1,13 und 11,3 W/cm2 bei einem Targetdurchmesser von 75 mm, Substrattemperatur unterhalb 200°C, HF-Substratpotential (Biasspannung) 0 bis -500 V, Schichtaufwachsrate zwischen 4,8 und 5,2 µm/h.

Für vergleichende Versuchsreihen wurden jeweils eine Einlagen-Verschleißschutzschicht aus TiC, TiC/C(30/70) und TiC/C(70/30) sowie jeweils zwei Viellagen-Verschleißschutzschichten mit je 50 und 500 sich periodisch wiederholter Abfolge abwechselnd aufgetragenen ersten und zweiten Einzellagen aus TiC/C(30/70) bzw. TiC/C(70/30) hergestellt und in Mess- und Versuchreihen miteinander verglichen. Dabei unterscheiden sich die beiden Exemplare einer Verschleißschutzschicht mit gleicher Anzahl von Lagen durch die obenliegende, d. h. freiliegende Einzellage (Decklage), welche bei je einem Exemplar (Gruppe 1) aus TiC/C(30/70), bei dem anderen (Gruppe 2) aus TiC/C(70/30) besteht. Entsprechend der Gesamtzahl der Einzelschichten unterscheiden sich die Verschließschutzschichten mit gleicher Einzelschichtzahl auch durch die Zusammensetzung der untersten, auf dem Substratmaterial aufgetragenen Einzelschicht. Als Substratmaterial diente jeweils der Stahl 100Cr6.

Tabelle 1 gibt einen vergleichenden Überblick der zuvor genannten Verschleißschutzschichten sowie eine Auswahl derer Eigenschaften. Die chemischen Zusammensetzung wurde mit Hilfe einer Elektronenstrahlmikrosonde sowie einer Auger-Elektronen-Spektroskopie (AES) analysiert. Die Dicke der Verschleißschutzschicht wurde mit dem sog. Carlo-Test, die Vickershärte als Mikrohärtemessung mit 0,5 N Prüflast sowie die kritische Last mit einem Scratch-Test (Last 20 N) durchgeführt. Der Reibwert sowie der Verschleißkoeffizient der Verschleißschutzschicht (Schicht) und einer als Verschleißpartner dienenden Kugelfläche aus Stahl 100Cr6 mit 6 mm Durchmesser wurden ohne weitere Schmierung an Luft bei 20°C und 50±10% relativer Feuchte in einem genormten Stift-Scheibe Verschleißversuch nach AISI/SAE 52100, DIN EN 10027:1.3505) ermittelt. Die Anpresskraft betrug dabei 10 N, die Reibgeschwindigkeit 3 cm/s, der Reibradius 4 mm sowie die Reibstrecke 1000 m.

**Tabelle 1: Eigenschaften von Monolayer- (Einlagen-) und Multilayer- (Mehrlagen-)Verschleißschutzschichten mit unterschiedlicher Stapelfolge (Gruppe 1 mit TiC/C(30/70), Gruppe 2 mit TiC/C(70/30) als Decklage)**

| Typ der Verschleißschutzschicht | Monolayer TiC/C (70/30) | Monolayer TiC/C (30/70) | Gruppe 1 | | Gruppe 2 | |
|---|---|---|---|---|---|---|
| | | | 500 Einzellagen | 50 Einzellagen | 500 Einzellagen | 50 Einzellagen |
| Chemische Zusammensetzung | 41,6 at% Ti, 55,6 at% C | 23,4 at% Ti, 75,4 at% C | | | | |
| Dicke [µm] | 4,9 | 5,9 | 10,5 | 6,2 | 10,2 | 6,3 |
| Kritische Last [N] | 27-30 | 20 | 20 | 19 | 25 | 20 |
| Vickershärte [HV_{0.05}] | 2865 | 1592 | 1809 | 1722 | 1762 | 1821 |
| Reibwert [ ] | 0,26 | 0,12 | 0,15 | 0,15 | 0,12 | 0,14 |
| Verschleißkoeff. Schicht [mm³/Nm] | 2.77 · 10⁻⁶ | 1.42 · 10⁻⁷ | 1.82 . 10⁻⁷ | 2.88 · 10⁻⁷ | 2.75 · 10⁻⁷ | 4.73 · 10⁻⁷ |
| Verschleißkoeffizient Kugel [mm³/Nm] | 1.68 · 10⁻⁷ | 0.63 · 10⁻⁷ | 1.19 · 10⁻⁶ | 7.91 · 10⁻⁷ | 1.47 · 10⁻⁶ | 1.074 · 10⁻⁶ |

Röntgenfeinstrukturuntersuchungen, Röntgenangeregte Elektronenspektroskopische Untersuchungen (XPS) sowie Untersuchungen am Transmissionselektronenmikroskop (TEM) an der Einlagen-Verschleißschutzschicht aus TiC/C(70/30) wiesen eine Dreiphasenmikrostruktur nach, bestehend aus einer nanokristalline TiC-Phase mit Kristallitgrößen unterhalb 20 nm, einer verzerrten TiC-Phase sowie einer amorphen Kohlenstoffphase. Dabei bilden die verzerrte TiC-Phase sowie die Kohlenstoffphase als metastabile Lösung die Grenzflächenphase der TiC-Phase. Die Verschleißwerte liegen im Bereich derer von Beschichtungen aus reinem TiC, während die Reibwerte knapp unterhalb derer liegen.

Ebenso wurden für TiC/C(30/70) in der Einlagen-Verschleißschutzschicht röntgenographisch und mit Untersuchungen am Transmissionselektronenmikroskop (TEM) TiC-Nanokristallite mit Kristallitgrößen keiner 5 nm nachgewiesen, welche im amorphen Kohlenstoff homogen verteilt sind. Der Reibwert dieser Verschleißschutzschicht liegt nur wenig oberhalb dem von reinen amorphen Kohlenstoff und damit nicht nur deutlich unterhalb dem der Einlagen-Verschleißschutzschicht aus TiC/C(70/30), sondern auch unterhalb dem von Diamantbeschichtungen. Die geringeren Verschleißvolumina von Verschließschutzschicht und Kugel gegenüber der TiC/C(70/30)-Verschließschutzschicht werden aufgrund der besseren Schmierung durch die größere Menge an amorpher Kohlenstoffphase in der Verschleißschutzschicht zu erklären.

Alle Verschleißschutzschichten, welche als Multilayer aus einer Vielzahl von Einzelschichten aufgebaut sind, wurden mit der AES untersucht. Die Einzelschichten zeigen keinerlei Durchmischung. Die Reibwerte sind bei beiden Gruppen im Bereich des günstigen Reibwerts von TiC/C(30/70), womit auch ein Einfluss sowohl der Anzahl der Einzelschichten wie auch die Zusammensetzung der freiliegenden obersten Einzellage (Deckschicht) in den Hintergrund tritt. Dagegen wird bei diesem günstigen Reibwert ein relativ hoher Verschleißkoeffizient realisiert, welches je nach gewünschten Einsatz einstellbar ist. Tendenziell steigt der Verschleißkoeffizient sowohl der Verschleißschutzschicht als auch der Kugelfläche , d. h. die Abtragsrate bei Festkörperreibung, mit steigenden TiC-Anteil, d. h. abnehmenden Kohlenstoffphasenanteil in der obersten Einzellage. Ferner verringert eine zunehmende Anzahl von dünner werdenden Einzelschichten bei gleichbleibender Dicke der Verschleißschutzschicht der Verschleißkoeffizient signifikant, was u. A. auf eine zunehmende Anzahl von Riss- und Ausbruchsbehindernden Materialübergängen zwischen den Einzellagen zurückzuführen ist. Aufgrund der geringeren Dicke der Einzelschichten weisen diese zudem einen geringeren Abstand zueinander auf und bewirken somit quasihomogenere Eigenschaften Materialeigenschaften mit geringeren Eigenspannungsniveaus in den Einzelschichten.

Das Verschleißverhalten lässt sich somit je nach dem, ob eine hoher Abtragsrate oder eine hohe Verschleißfestigkeit erwünscht ist, durch den Schichtaufbau optimieren.

In einem zweiten Ausführungsbeispiel enthält die Verschleißschutzschicht bei ansonsten unveränderten Parametern einen Hartstoffanteil, welcher aus metastabilen Titanaluminiumcarbonitrid (TiAlCN) oder metastabilen Titanaluminiumnitrid (TiAlN) gebildet wird.

Wie im ersten Ausführungsbeispiel erfolgte die Beschichtung auf einem polierten Substrat aus einem Stahl 100Cr6 oder Hartmetall in der gleichen Beschichtungsanlage, wobei jedoch anstelle der Ti- und TiC-Targets konventionelle TiAl-Targests zum Einsatz kamen. Die Beschichtung erfolgte in einer Atmosphäre unter einem Zufluss von 200 sccm Argon, 28-32 sccm Stickstoff und 5-30 sccm Metangas. Die Sputterleistung wurde auf 6 kW DC ohne zusätzliches magnetisches Feld eingestellt, bei einer Substrattemperatur von 100-400°C und einem Substratpotential (Biasspannung) von 80 V DC.

Über Verschleißmessungen an acht Proben mit einer Kugelfläche aus Stahl 100Cr6 mit 6 mm Durchmesser bestimmten sich die Reibwerte zu ca. 0,1 und die Verschleißkoeffizienten zu ca. 1*10⁻⁷. Die Durchführung der Verschleißmessungen wurden bereits im ersten Ausführungsbeispiel beschrieben. Ebenso wurde in einer im Rahmen des ersten Ausführungsbeispiels analogen Weise Vickers-Härten zwischen 1380 und 1950 HV0,05 und die kritischen Lasten mit Scratch-Tests im Bereich zwischen 20 und 95 gemessen. Alle_Proben wiesen 100 bis 200 Lagen bei einer Gesamtschichtverbunddicke von ca. 5 µm auf.

## Patentansprüche

1. Verschleißschutzschicht, bestehend aus einer Vielzahl von in periodisch wiederholter Abfolge auf ein Substrat abwechselnd übereinander aufgetragenen ersten und zweiten Einzellagen, welche jeweils mindestens eine Hartstoffphase enthalten,
**dadurch gekennzeichnet, dass**
a. die Einzellagen eine amorphe Kohlenstoffphase enthalten, welche als eine Matrix oder eine Korngrenzenphase für die Hartstoffphase dient, wobei sich die Einzellagen aus den gleichen Phasen, jedoch mit unterschiedlichen Phasenanteilen, zusammensetzen und eine stoffschlüssige Verbindung der Einzellagen untereinander bilden,
b. die erste Einzellage einen Kohlenstoffphasenanteil von über 50mol% Kohlenstoff aufweist,
c. die zweite Einzellage einen Hartstoffphasenanteil von über 50mol% des Hartstoffs aufweist, sowie
d. der Hartstoffphasenanteil nanokristallin ist.

2. Verschleißschutzschicht nach Anspruch 1, **dadurch gekennzeichnet, dass** die Hartstoffphasen durch metastabiles Titanaluminiumnitrid oder metastabiles Titanaluminiumcarbonitrid gebildet werden.

3. Verschleißschutzschicht nach Anspruch 1, **dadurch gekennzeichnet, dass** die Hartstoffphasen durch Titankarbid gebildet werden.

4. Verschleißschutzschicht nach Anspruch 2 oder 3, **dadurch gekennzeichnet, dass** in der ersten Einzellage der Hartstoffanteil 30 mol% und der Kohlenstoffanteil 70 mol%, sowie in der zweiten Einzellage der Hartstoffanteil 70 mol% und der Kohlenstoffanteil 30 mol% beträgt.

5. Verschleißschutzschicht nach einem der Ansprüche 2 bis 4, **dadurch gekennzeichnet, dass** die Hartstoffphase der ersten Einzellage eine Kristallitgröße bis maximal 5 nm und der zweiten Einzellage eine Kristallitgröße bis maximal 20 nm aufweist.

6. Verschleißschutzschicht nach einem der vorangegangenen Ansprüche, **dadurch gekennzeichnet, dass** die Vielzahl der Einzellagen zwischen 10 und 1000 Einzellagen umfasst.

7. Verschleißschutzschicht nach Anspruch 6, **dadurch gekennzeichnet, dass** die Vielzahl der Einzellagen zwischen 100 und 200 Einzellagen umfasst.

8. Verschleißschutzschicht nach einem der vorangegangenen Ansprüche, **dadurch gekennzeichnet, dass** die Einzellagen Dicken zwischen 5 und 500 nm aufweisen.

9. Verschleißschutzschicht nach einem der vorangegangenen Ansprüche, **dadurch gekennzeichnet, dass** die Vielzahl der Einzelschicht ein Schichtverbund mit einer Gesamtschichtdicke von ca. 5 µm ist.

## Claims

1. Wear resistant coating comprising a multiplicity of first and second single layers which are applied in a periodically repeated sequence on a substrate alternately one above the other and contain respectively at least one hard material phase,
**characterised in that**
a. the single layers contain an amorphous carbon phase which serves as a matrix or a particle boundary phase for the hard material phase, the single layers being composed of the same phases but with different phase components and together forming an integral connection of the single layers,
b. the first single layer has a carbon phase component of over 50% by mol of carbon,
c. the second single layer has a hard material phase component of over 50% by mol of the hard material, and
d. the hard material phase component is nanocrystalline.

2. Wear resistant coating according to claim 1, **characterised in that** the hard material phases are formed by metastable titanium aluminium nitride or metastable titanium aluminium carbonitride.

3. Wear resistant coating according to claim 1, **characterised in that** the hard material phases are formed by titanium carbide.

4. Wear resistant coating according to claim 2 or 3, **characterised in that**, in the first single layer, the hard material component is 30% by mol and the carbon component is 70% by mol and, in the second single layer, the hard material component is 70% by mol and the carbon component is 30% by mol.

5. Wear resistant layer according to one of the claims 2 to 4, **characterised in that** the hard material phase of the first single layer has a crystallite size up to at most 5 nm and the second single layer has a crystallite size up to at most 20 nm.

6. Wear resistant coating according to one of the preceding claims, **characterised in that** the multiplicity of single layers comprises between 10 and 1000 single layers.

7. Wear resistant coating according to claim 6, **characterised in that** the multiplicity of single layers comprises between 100 and 200 single layers.

8. Wear resistant coating according to one of the preceding claims, **characterised in that** the single layers have thicknesses between 5 and 500 nm.

9. Wear resistant coating according to one of the preceding claims, **characterised in that** the multiplicity of single coatings is a coating composite having an overall coating thickness of approx. 5 µm.

## Revendications

1. Couche anti-usure, constituée d'une pluralité de premières et deuxièmes couches individuelles appliquées en alternance l'une au-dessus de l'autre sur un substrat dans une séquence se répétant périodiquement, constituées respectivement d'au moins une phase dure,
**caractérisée en ce que**
a. les couches individuelles contiennent une phase de carbone amorphe servant de matrice ou de phase intergranulaire pour la phase dure, les couches individuelles étant constituées des mêmes phases mais avec des fractions de phase différentes et formant entre elles une liaison par liaison de matière des couches individuelles,
b. la première couche individuelle présente une fraction de phase de carbone supérieure à 50 % en moles de carbone,
c. la deuxième couche individuelle présente une fraction de phase dure supérieure à 50 % en moles de matière dure, et
d. la fraction de phase dure est nanocristalline.

2. Couche anti-usure selon la revendication 1,
**caractérisée en ce que**
les phases dures sont constituées de nitrure de titane-aluminium métastable ou de carbonitrure de titane-aluminium métastable.

3. Couche anti-usure selon la revendication 1,
**caractérisée en ce que**
les phases dures sont constituées de carbure de titane.

4. Couche anti-usure selon la revendication 2 ou la revendication 3,
**caractérisée en ce que**
la fraction dure est de 30 % en moles et la fraction de carbone de 70 % en moles dans la première couche individuelle, alors que deuxième couche individuelle dans la fraction dure est de 70 % en moles et la fraction de carbone de 30 % en moles.

5. Couche anti-usure selon l'une quelconque des revendications 2 à 4,
**caractérisée en ce que**
la phase dure de la première couche individuelle présente des cristallites mesurant au maximum 5 nm, et celle de la deuxième couche individuelle des cristallites mesurant au maximum 20 nm.

6. Couche anti-usure selon l'une quelconque des revendications précédentes,
**caractérisée en ce que**
la pluralité de couches individuelles comporte entre 10 et 1000 couches individuelles.

7. Couche anti-usure selon la revendication 6,
**caractérisée en ce que**
la pluralité de couches individuelles comporte entre 100 et 200 couches individuelles.

8. Couche anti-usure selon l'une quelconque des revendications précédentes,
**caractérisée en ce que**
les couches individuelles ont des épaisseurs comprises entre 5 et 500 nm.

9. Couche anti-usure selon l'une quelconque des revendications précédentes,
**caractérisée en ce que**
la pluralité de couches individuelles est un empilement de couches d'une épaisseur totale d'environ 5 µm.
